# EUROPEAN PATENT APPLICATION

(11) **EP 0 763 903 A1**
(43) Date of publication of application: **19.03.1997**
(21) Application number: 95114495.5
(22) Date of filing: 15.09.1995
(51) Int. Cl.: H04B 1/00, H03G 5/00, H03H 17/02

(54) **Communication apparatus**

(71) Applicant: Hagenuk Telecom GmbH, 24118 Kiel (DE)
(72) Inventor: Bjerre, Bjarne, DK-7800 Skive (DK)
(74) Representative: Hansmann, Dierk, Dipl.-Ing.

(57) **Abstract**

The audio components apparatus (ear-piece, microphone) must be cheap and small. This may result in sorting out of components which do not comply with the quality standard. Testing and sorting is costly. According to the invention the communication apparatus contains variable control means to adjust frequency response and level. Thus deficiencies in the components are balanced.

## Description

This invention relates to a communication apparatus, particularly but not exclusivly a hand-held portable cellular telephone or mobile terminal.

Modern mobile terminals must be small and cheap, which requires small and low-cost acoustic components like ear-pieces and microphones.

These low cost acoustic components, usually produced in big numbers, show a big spreadening of sensitivity and frequency response.

On the other hand communication systems like GSM or DECT give recommendations concerning frequency response and level.

In order to comply with the recommendations it is normally neccessary to sort the acoustic components from mass production. This requires testing and results in low production efficiency, making the sorted components more costly.

It must be pointed out, that not only the acoustic components individually vary in frequency response and level but also other components in the audio signal path contribute to the acoustical performance of the terminal.

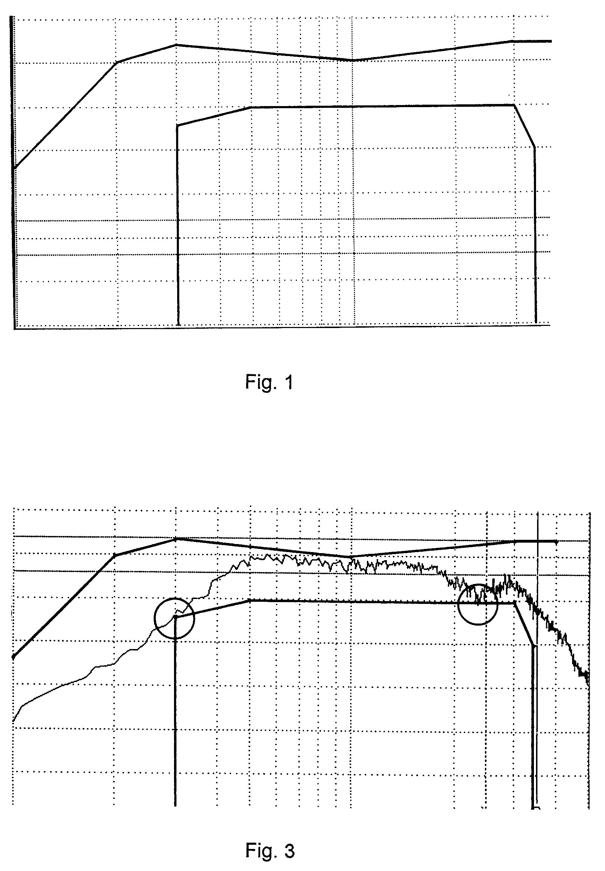

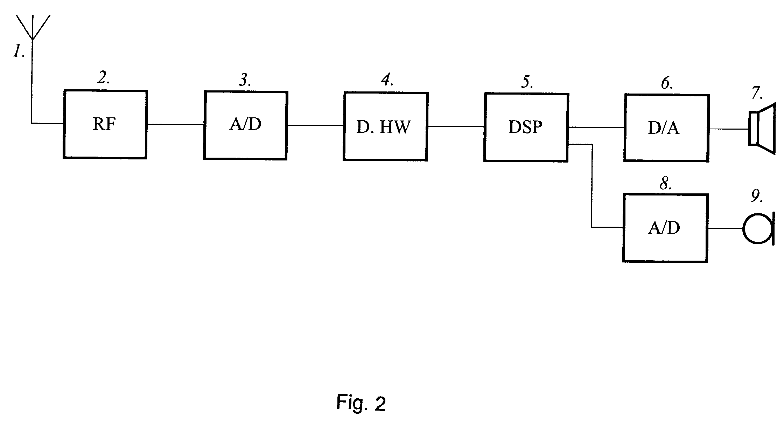

By way of example for GSM the quipment must show a fairly uniform frequency response in the band from 300 to 3400 Hz as shown in fig. 1.

Clearly the problem of spreadening in frequency response and level for the terminals in mass production can not be solved by sorting. This would be much to costly.

The audio signal path with its main functional blocks is shown by way example in fig. 2. It includes antenna 1, RF-part 2, A/D converter 3, digital hardware (d.h.) 4, digitals signal processor (d.s.p.) 5, D/A converter 6 and earpiece 7. The microphone is also connected to the digital signal processor via A/D 8.

Additional problems arise when interfacing (acoustically connecting) the terminal to the user and his equipment. The user himself has an individual sensitivity. For example, some people have a lower sensitivity at frequencies above 1 kHz. This can be balanced at least partly by adjusting the level. Also this could be used as a hearing aid, at least to a certain extent, which is especially useful in occasionally noisy transmissions. For speech control puposes adjusting the level at special frequencies will improve reliability of speech recognition.

The solution to these problems is to include into the communication equipments variable control means to adjust frequency response and level in a predetermined frequency band and level range.

By adjusting the variable control means differently according to the application different requirements specific to the application can be met.

E.g. in the production of the mobile terminal the spreadening of sensitivity and frequency response of cheap acoustical components and the impact of all the other components in the audio signal path on the terminal's acoustical performance can be measured and deficiencies can be balanced by settings to the variable control means. Thus the acoustical performance of each terminal can automatically and individually be optimized, giving a high production yield.
Alternatively by adapting the settings to the special requirements of speech recognition, the communication reliability will be improved.
Finally the settings to the variable control means may be adapted to the users frequency dependent sensitivity.

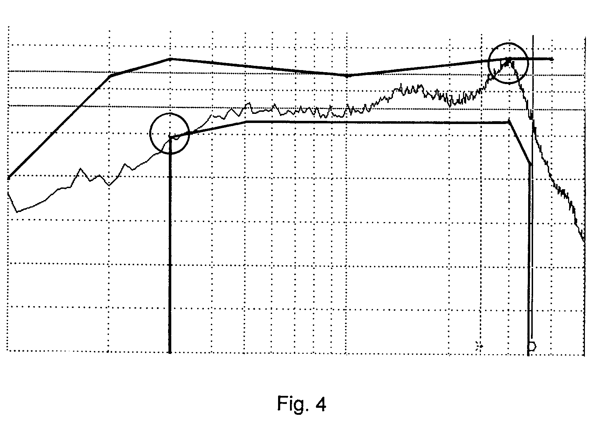

In a prefered embodiment of the invention the audio signal path includes digital hardware and the variable control means are variable digital filters. Using these filters frequency responses which do not comply with the reommendations, as shown by way of example in fig. 3 and 4, can be adjusted. These digital filters therefore directly affect the audio signal.

In a more prefered embodiment of the invention the audio signal path includes a digital signal processor and the digital filters are include in the digital signal processor as part of its programme. The digital filters then action as an adjustable filter function.

For example, when setting the filter function in production of the terminal, a calibrated microphone is placed close to the earpiece and digital signals corresponding to tones in the frequency band 100 - 4000 Hz are fed to the digital hardware or the digital signal processor.

The signal received by the microphone is measured, the coefficients for the filter function are calculated and stored in non volatile memory of the digital hardware accessible by the digital signal processor. A similar calibration is done for the microphone using a calibrated loudspeaker.
The user may via the man-machine interface have the chance to adapt the filter function according to his senisitivity. To achieve this, test signals are generated by switching between a low frequency and one or more higher frequencies. The user can adjust the filter function to give almost equal acoustical levels at the various frequencies.
Additionally the filter function may be adjusted to cope with losses of low frequencies due to high impedance of the small earpieces. Therefore the acoustical level particularly of low frequency components of DTMF tones can be adjusted to approximately the level of the high frequency components.

## Claims

1. Communication apparatus including an audio signal path, characterized in that, variable control means to adjust the frequency response and the level in a predetermined frequency band and level range or included in the audio signal path.

2. Communication apparatus according to claim 1, characterized in that, the audio signal path includes digital hardware and the variable control means are variable digital filters.

3. Communication apparatus according to claim 2, characterized in that the audio signal path includes a digital signal processor and the digital filters are included in the digital signal processor.

4. Communication apparatus according to claims 1 to 3, characterized in that, test tones are generated comprising a low frequency and one ore more higher frequency.
